# EUROPEAN PATENT SPECIFICATION

(11) **EP 0 590 781 B1**
(45) Date of publication and mention of the grant of the patent: **21.05.1997**
(21) Application number: 93306588.0
(22) Date of filing: 19.08.1993
(51) Int. Cl.: H01L 21/316, H01L 21/56, C04B 41/50, H01L 23/29, H01L 23/31, H01L 23/485, C04B 41/45

(54) **Method for producing an integrated circuit with hermetic protection based on a caramic layer**
Verfahren zur Herstellung einer integrierten Schaltung mit einem auf einer Keramikschicht basierenden Schutz
Méthode de formation d'un circuit intégré avec protection hermétique basée sur une couche céramique

(30) Priority: 31.08.1992 US 937086
(43) Date of publication of application: 06.04.1994
(73) Proprietor: DOW CORNING CORPORATION, Midland Michigan 48686-0994 (US)
(72) Inventor: Chandra, Grish, Midland, Michigan (US); Michael, Keith Winton, Midland, Michigan (US)
(74) Representative: Lewin, John Harvey

(56) References cited:
- EP-A- 0 323 186
- EP-A- 0 427 395
- DE-A- 3 805 490
- US-A- 4 888 226
- US-A- 5 136 364
- PROCEEDINGS SPIE - CONF. ON RAPID THERMAL AND INTEGRATED PROCESSING vol. 1595, 10 September 1991, SAN JOSE, CA, USA pages 146 - 164 T.E. GENTLE 'Oxidation of hydrogen silsesquioxane (HSiO3/2)n by rapid thermal processing'
- ELECTRONIC PACKAGING AND PRODUCTION vol. 32, no. 2, February 1992, MASSACHUSSETS US page 35 'Packaging ideas: Protective layer eliminates MCM package'
- ELECTRONIC PACKAGING MATERIAL SCIENCE SYMPOSIUM 26 November 1990, BOSTON pages 97 - 108 GRISH CHANDRA 'Low temperature ceramic coatings for environmental protection of integrated circuits'

## Description

The present invention relates to a method of making integrated circuits which are protected from the environment. Such circuits are hermetically sealed by applying ceramic layers to the top metallization. These circuits are inexpensive to fabricate and have improved performance and reliability.

Modern electronic circuits must be able to withstand a wide variety of environmental conditions such as moisture, ions, heat and abrasion. A significant amount of work has been directed toward various protective measures to minimize the exposure of such circuits to the above conditions and thereby increase their reliability and life.

Many prior art processes for protecting electronic circuits involve sealing or encapsulating the circuits after they have been interconnected. For example, it is known in the art to use protective layers of silicones, polyimides, epoxies, other organics, plastics and the like. Such materials, however, are of only limited value since most are permeable to environmental moisture and ions.

Similarly, interconnected circuits have also been sealed within ceramic packages. This latter approach has proven to be relatively effective in increasing device reliability and is currently used in select applications. The added size, weight and cost involved in this approach, however, inhibits widespread application in the electronic industry.

Proceedings of SPIE, volume 1595, Conference on Rapid Thermal and Integrated Processing, San Jose, CA., USA, 10-11 September 1991, pages 146-164 (Theresa E. Gentle) reports the evaluation of hydrogen silsesquioxane (HSiO_{3/2})ₙ, referred to as an H-resin, as a precursor of silica coatings used to protect electronic devices. Rapid Thermal Processing (RTP) is used to convert the H-resin to silica at temperatures as low as 400°C with minimal to no adverse effects on temperature sensitive integrated circuits. The first coating in direct contact with the circuit surface is a silica coating derived from the H-resin. The H-resin is applied from solution by spin coating, drop coating or spray coating and the deposited coating is then oxidized to silica. The technique of rapid thermal processing (RTP) is a short-time, thermal processing technique based on incoherent sources of light. An evaluation of the effect of RTP on lead wire bond strength and on the formation of intermetallics ("purple plague") at the bond welds showed that the bond strength was minimally affected by the RTP treatment as compared with untreated devices and with devices subjected to conventional furnace processing. In the case of RTP processing, no evidence of "purple plague" was seen, whereas devices processed at 250°C in a furnace showed by optical microscopy clear signs of "purple plague".

US-A-5,136,364 (Robert C. Byrne) provides a metallization layer sequence for a semiconductor integrated circuit (IC) device in which a passivation layer covers the edges of the metallization layers, thereby rendering them immune to attack by contaminants. An IC bonding pad is provided with a passivation layer which overlaps the edges thereof so as to leave the central portion exposed. A sequence of metal layers comprises an optional layer of aluminum for adherence, a barrier metal layer to metallurgically isolate the aluminum and a noble metal contact layer. The edges of the metal layer sequence are overlapped by an upper passivation layer which seals their edges and renders them immune to chemical contaminants. The upper passivation layer may also include a silicon dioxide and nitride combination or silicon carbide and may further include layers of glass and/or polyimide or other organic coatings.

Electronic Packaging and Production, Volume 32, No. 2, February 1992, page 35, Newton, Mass., USA (Edited by Howard Markstein) describes a surface protected electronic circuit (SPEC) which comprises a first layer of silica (SiO₂) which planarizes the surface and seals around the bonding sites in addition to filling in any pin holes or cracks which may be in the primary passivation layer after IC fabrication, and a second coating which is a layer of silicon carbide that hermetically seals the circuit and bonding wires to form a moisture and ionic barrier. The silica is applied to the multichip modules (MCM) by spin, dip, drop or spray coating. The material is in the form of a liquid silica precursor (hydrogen silsesquioxane) that is then pyrolysed to form the SiO₂ layer. The silicon carbide is applied by plasma enhanced chemical vapour deposition using siliacyclobutane.

The use of lightweight ceramic protective coatings on electronic devices has also been suggested in U.S. Patents 4,756,977 and 4,749,631. The use of ceramic silica coatings are described therein which are derived from hydrogen silsesquioxane and silicate esters, respectively, as well as the use of additional ceramic layers as hermetic barriers. We have discovered that when such coatings are applied specifically to integrated circuits at the wafer stage and, even though the bond pads are subsequently opened by removing a portion of the coating, the resultant circuits remain hermetically sealed and exhibit increased reliability and life.

Sealing circuits at the wafer stage is also known in the art. For example, it is known in the art to coat fabricated integrated circuits with ceramic materials such as silica and/or silicon nitride by chemical vapor deposition (CVD) techniques. These coatings are then etched back to the bond pads for the application of leads. The wafers coated in this manner, however, have inadequate reliability and life.

We have found a solution to the above problems associated with the hermetic protection of integrated circuits by replacing the conventional passivation layers on integrated circuits with the silicon-containing ceramic coatings described herein.

The present invention relates to a method of making hermetically sealed integrated circuits. These circuits comprise circuit subassemblies having a top layer of metallization including one or more bond pads. To this top layer of metallization is applied a silicon-containing ceramic layer by a process comprising coating the circuit with a composition comprising a preceramic silicon-containing material followed by converting said material to a ceramic. The ceramic layers covering the bond pad(s) is (are) removed and the resultant open bond pads sealed with one or more non-corroding, conductive layers. Thus, the method involves applying one or more ceramic layers onto the top layer of metallization on the circuit followed by removing at least a portion of the ceramic layer or layers covering the bond pads.

Accordingly, the present invention provides a method of providing an integrated circuit with hermetic protection, which comprises in sequence the steps of:
(i) applying, at the wafer stage before interconnection of said circuit, to a circuit subassembly comprising a semiconductor substrate having at least one bond pad, at least one preceramic coating comprising a preceramic silicon-containing material selected from hydrogen silsesquioxane resins (H-resins) having units of the structure HSi(OH)ₓ(OR)_{y}O_{z/2}, in which each R is independently an organic group which, when bonded to silicon through the oxygen atom, forms a hydrolysable substituent, x = 0-2, y = 0-2, z =1-3 and x + y + z = 3, various units of said H-resins having either 0 or more than one Si-H bond and hydrolyzed or partially hydrolyzed compounds of the formula RₙSi(OR)₄₋ₙ in which each R is independently an aliphatic, alicyclic or aromatic substituent of 1-20 carbon atoms and n is 0-3, and converting said coating(s) of preceramic material to at least one silicon-containing ceramic layer by heating said preceramic material to a temperature in the range of from 50 to 800°C for a time sufficient to ceramify said preceramic material;
(ii) optionally providing onto said at least one ceramic layer of step (i) at least one additional coating selected from SiO₂ coatings, SiO₂ -ceramic oxide coatings, silicon-containing coatings, silicon-carbon-containing coatings, silicon-nitrogen-containing coatings, silicon-oxygen-nitrogen coatings, silicon-nitrogen-carbon-containing coatings and/or diamond-like carbon coatings;
(iii) removing by etching at least a portion of said ceramic layer(s) of step (i) and of said additional coating(s), if any, of step (ii) covering said bond pad(s) to allow for the attachment of leads thereto;
(iv) sealing the open bond pad(s) by covering the pad(s) with one or more non-corroding, conductive layers; and
(v) interconnecting said circuit subassembly to form the desired hermetically sealed integrated circuit.

The present invention is based on our finding that integrated circuits can be hermetically sealed by the application of the ceramic coatings taught herein onto the top layer of metallization on the circuit. These sealed circuits have increased reliability and performance. In addition, since this process is unexpectedly performed at the wafer stage, production can be simplified and costs reduced.

The integrated circuit subassemblies used in the process of this invention are not critical and nearly any which are known in the art and/or produced commercially are useful herein. The processes used to produce such circuits are also known and not critical to the invention. Exemplary of such circuits are those comprising a semiconductor substrate, such as silicon or gallium arsenide, having an epitaxial layer grown thereon. This epitaxial layer is appropriately doped to form the PN-junction regions which constitute the active regions of the device. These active regions are diodes and transistors which form the integrated circuit when appropriately interconnected by a properly patterned metallic layer. This metallic interconnect layer terminates at the bond pads on the exterior surface of the circuit subassembly.

As described above, the prior art discloses passivating such circuits with one or more ceramic coatings applied by CVD techniques. These coatings included, for example, silica, silicon nitride or silicon oxynitride derived from precursors such as silane and oxygen, nitrous oxide, nitrogen, ammonia or the like. Circuits coated with such a passivation layer, however, are still prone to damage by the environment. For example, the passivation is prone to penetration of water and/or various destructive ions through defects and cracks. As noted above, the circuit industry has attempted to solve these problems by the use of additional protective measures after the circuits are interconnected. The present invention, on the other hand, describes the application of specific ceramic coatings before the interconnection.

In the process of the present invention, the above circuits are sealed by covering the circuit's top metallization with one or more ceramic layers. The first layer is a silicon-containing ceramic material which is applied by a process comprising coating the circuit with a composition comprising a preceramic silicon-containing material followed by converting the preceramic silicon-containing material to a ceramic. Typically, the preceramic material is converted to a ceramic by heating it to a sufficient temperature.

As used in the present invention, the term "preceramic silicon-containing material" describes material which can be rendered sufficiently flowable to impregnate and coat the surface of a circuit and which can be subsequently converted to a solid layer exhibiting properties generally recognized by those skilled in the art as characteristic of a ceramic. These materials include, for example, precursors to silicon oxides, silicon nitride, silicon oxynitride, silicon oxycarbide, silicon carbonitride, silicon oxycarbonitride, silicon carbide and the like.

The preceramic compounds to be used in the process of this invention are precursors to silicon oxides, especially silica. The silica precursors which are used in the invention include hydrogen silsesquioxane resin (H-resin), hydrolyzed or partially hydrolyzed RₙSi(OR)₄₋ₙ, or their combinations, in which each R is independently an aliphatic, alicyclic or aromatic substituent of 1-20 carbon atoms, preferably 1-4 carbon atoms, such as an alkyl (e.g., methyl, ethyl, propyl), alkenyl (e.g., vinyl or allyl), alkynyl (e.g., ethynyl), cyclopentyl, cyclohexyl and phenyl and n is 0-3, preferably 0-1.

H-resin is used in this invention to describe a variety of hydridosilane resins having units of the structure HSi(OH)ₓ(OR)_{y}O_{z/2} in which each R is independently an organic group which, when bonded to silicon through the oxygen atom, forms a hydrolyzable substituent, x = 0-2, y = 0-2, z = 1-3 and x + y + z = 3. These resins may be either fully condensed (x = 0, y = 0 and z = 3) or they may be only partially hydrolyzed (y is not 0 over all the units of the polymer) and/or partially condensed (x is not 0 over all the units of the polymer). Although not represented by this structure, various units of these resins may have either zero or more than one Si-H bond due to various factors involved in their formation and handling. Exemplary of substantially condensed (less than about 300 ppm silanol) H-resins are those formed by the process in U.S. Patent 3,615,272. This polymeric material has units of the formula (HSiO_{3/2})ₙ in which n is generally 8-1000. The preferred resin has a number average molecular weight of from 800-2900 and a weight average molecular weight of between 8000-28,000 (obtained by gel permeation chromatography (GPC) analysis using polydimethylsiloxane as a calibration standard). When heated sufficiently, this material yields a ceramic coating essentially free of SiH bonds.

Exemplary H-resins which may not be fully condensed include those described in U.S. Patent 5,010,159 or U.S. Patent 4,999,397. Exemplary H-resins which are not fully hydrolyzed or condensed are formed by a process which comprises hydrolyzing a hydrocarbonoxy hydridosilane with water in an acidified oxygen-containing polar organic solvent.

A platinum, rhodium or copper catalyst may also be admixed with the hydrogen silsesquioxane to increase the rate and extent of its conversion to silica. Any platinum, rhodium or copper compound or complex that can be solubilized with the catalyst will be operable. For instance, an organo-platinum composition such as platinum acetylacetonate or rhodium catalyst RhCl₃[S(CH₂CH₂CH₂CH₃)₂]₃, obtainable from Dow Corning Corporation, Midland, Michigan are all within the scope of this invention. The above catalysts are generally added to the solution in an amount of between about 5 and 500 ppm platinum or rhodium based on the weight of resin.

The second type of silica precursor material useful herein includes hydrolyzed or partially hydrolyzed compounds of the formula RₙSi(OR)₄₋ₙ in which R and n are as defined above. Some of these materials are commercially available, for example, under the tradename ACCUGLASS. Specific compounds of this type include methyltriethoxysilane, phenyltriethoxysilane, diethyldiethoxysilane, methyltrimethoxysilane, dimethyldimethoxysilane, phenyltrimethoxysilane, vinyltrimethoxysilane, tetramethoxysilane, tetraethoxysilane, tetrapropoxysilane and tetrabutoxysilane. After hydrolysis or partial hydrolysis of these compounds, the silicon atoms therein may be bonded to C, OH or OR groups, but a substantial portion of the material is believed to be condensed in the form of soluble Si-O-Si resins. Compounds in which x = 2 or 3 are generally not used alone as volatile cyclic structures are generated during pyrolysis, but small amounts of said compounds may be cohydrolyzed with other silanes to prepare useful preceramic materials.

In addition to the above SiO₂ precursors, other ceramic oxide precursors may also be advantageously used herein either solely or in combination with the above SiO₂ precursors. The ceramic oxide precursors specifically contemplated herein include compounds of various metals such as aluminum, titanium, zirconium, tantalum, niobium and/or vanadium as well as various non-metallic compounds such as those of boron or phosphorous which may be dissolved in solution, hydrolyzed and subsequently pyrolyzed at relatively low temperatures to form ceramic oxides.

The above ceramic oxide precursor compounds generally have one or more hydrolyzable groups bonded to the above metal or non-metal, depending on the valence of the metal. The number of hydrolyzable groups to be included in these compounds is not critical as long as the compound is soluble in the solvent. Likewise, selection of the exact hydrolyzable substituent is not critical since these substituents are either hydrolyzed or pyrolyzed out of the system. Typical hydrolyzable groups include alkoxy, such as methoxy, propoxy, butoxy and hexoxy; acyloxy, such as acetoxy, other organic groups bonded to said metal or non-metal through an oxygen atom such as acetylacetonate or amino groups. Specific compounds, therefore, include zirconium tetracetylacetonate, titanium dibutoxy diacetylacetonate, aluminum triacetylacetonate, tetraisobutoxy titanium and Ti(N(CH₃)₂)₄.

When SiO₂ is to be combined with one of the above ceramic oxide precursors, generally it is used in an amount such that the final ceramic contains 70 to 99.9 percent by weight SiO₂.

Examples of suitable silicon carbonitride precursors include hydridopolysilazane (HPZ) resin and methylpolydisilylazane (MPDZ) resin. Processes for the production of these materials are described in US Patents 4,540,803 and 4,340,619. Examples of silicon carbide precursors include polycarbosilanes and examples of silicon nitride precursors include polysilazanes. Oxygen can be incorporated into the ceramics resulting from the above precursors by pyrolyzing them in an oxygen-containing environment.

The above preceramic material is then used to coat the integrated circuit. The material can be used in any practical form but it is preferred to use a solution comprising the preceramic material in a suitable solvent. If this solution approach is used, the preceramic solution is generally formed by simply dissolving or suspending the preceramic material in a solvent or mixture of solvents. Various facilitating measures such as stirring and/or heat may be used to assist in the dissolution. The solvents which may be used in this method include alcohols such as ethyl or isopropyl; aromatic hydrocarbons such as benzene or toluene; alkanes such as n-heptane or dodecane; ketones; cyclic dimethylpolysiloxanes; esters and glycol ethers, in an amount sufficient to dissolve the above materials to low solids. For instance, enough of the solvent should be included to form a 0.1-85 weight percent solution.

The circuit is then coated with this solution by means such as spin, spray, dip or flow coating and the solvent is allowed to evaporate. Any suitable means of evaporation such as simple air drying by exposure to the ambient environment, heating or the application of a vacuum may be used.

Although the above described methods primarily focus on using a solution approach, one skilled in the art would recognize that other equivalent means (eg., melt impregnation) would also function in the process of this invention.

The preceramic material is then typically converted to a silicon-containing ceramic by heating it to a sufficient temperature. Generally, the temperature is in the range of 50 to 800°C. depending on the pyrolysis atmosphere and the preceramic compound. Preferred temperatures are in the range of 50 to 600°C. and more preferably are 50-400°C. Heating is generally conducted for a time sufficient to ceramify, generally up to 6 hours, with less than 2 hours being preferred.

The above heating may be conducted at any effective atmospheric pressure from vacuum to superatmospheric and under any effective oxidizing or non-oxidizing gaseous environment such as those comprising air, O₂, an inert gas (N₂, etc.), ammonia, amines, moisture, N₂O and the like.

Any method of heating such as the use of a convection oven, rapid thermal processing, hot plate or radiant or microwave energy is generally functional herein. The rate of heating, moreover, is also not critical, but it is most practical and preferred to heat as rapidly as possible.

Additional coatings may be applied over these coatings if desired. These can include, for example, SiO₂ coatings, SiO₂/ceramic oxide layers, silicon-containing coatings, silicon-carbon containing coatings, silicon-nitrogen containing coatings, silicon-oxygen-nitrogen coatings, silicon-nitrogen-carbon containing coatings and/or diamond-like carbon coatings. Methods for the application of such coatings are known in the art and many are described in U.S. Patent 4,756,977. An especially preferred coating is silicon carbide applied by CVD of silacyclobutane as is described in U.S. Patent 5,011,706.

After the ceramic layers are applied, the coating covering the bond pads can be etched or partially etched to allow for attachment of leads. The method of etching is not critical and nearly any process known in the art will function herein. This includes, for example, dry etching (eg., with plasma), wet etching (eg., with hydrofluoric acid) and/or laser ablation. The open bond pads can then be sealed by covering them with one or more non-corroding, conductive layers. The material used for this layer is not critical and can comprise any which is stable in the environment, electrically conductive and useful for interconnecting the circuit. Examples of such materials include gold, copper, silver, tungsten, solder, silver-filled epoxy and the like.

The method for applying this layer or layers is likewise not critical. Examples of such processes include sputtering, electron beam evaporation or by merely dispensing the material at the bond pad. These and other processes are known in the art for use within the multiple layers of the circuit and are functional herein.

It should be noted that the materials of the bond pad (eg., aluminum) are often incompatible with the materials of the non- corroding, conductive layer (eg, gold) such that when they are brought into contact with each other intermetallic formation ("purple plague") can damage the circuit. To prevent such damage, it is within the scope of this invention to first apply a diffusion barrier metal layer to the bond pads followed by application of the conductive layers as set forth above. The diffusion barrier metal layers useful herein are known in the art for use within integrated circuits for building the multiple layers of the circuit. Generally, such layers comprise metals such as tungsten or metal alloys such as titanium-tungsten, titanium nitride and the like.

The method for forming the diffusion barrier metal layers is not critical and many techniques are known in the art. A common approach involves sputtering the diffusion barrier metal layer on the surface of the circuit followed by etching.

If the bond pads are sealed with this conductive layer, additional ceramic coatings may be added to the above ceramic layers by the methods described above to further seal the circuit.

The above sealing processes are performed at the wafer stage.

The integrated circuits formed in the manner of this invention are hermetically sealed such that their reliability is increased. In addition, the circuits can be handled and manipulated without damage. Furthermore, many of the ceramic layers are opaque to UV and visible light.

Such circuits are then interconnected with each other, with a lead frame, with a circuit board or other external components. Such interconnection can be by conventional leads or by methods such as TAB or "flip chip" processes which are well known in the art.

After interconnection, the device can also be packaged by conventional techniques known in the art. For instance, the device can be embedded within an organic encapsulant such as a polyimide, an epoxy or PARYLENE^{TM}. It can also be embedded within a silicone encapsulant or it can be included in a plastic package for additional protection.

## Claims

1. A method of providing an integrated circuit with hermetic protection, which comprises in sequence the steps of:
(i) applying, at the wafer stage before interconnection of said circuit, to a circuit subassembly comprising a semiconductor substrate having at least one bond pad, at least one preceramic coating comprising a preceramic silicon-containing material selected from hydrogen silsesquioxane resins (H-resins) having units of the structure HSi(OH)ₓ(OR)_{y}O_{z/2}, in which each R is independently an organic group which, when bonded to silicon through the oxygen atom, forms an hydrolysable substituent, x = 0-2, y = 0-2, z =1-3 and x + y + z = 3, various units of said H-resins having either 0 or more than one Si-H bond, and hydrolyzed or partially hydrolyzed compounds of the formula RₙSi(OR)₄₋ₙ, in which each R is independently an aliphatic, alicyclic or aromatic substituent of 1-20 carbon atoms and n is 0-3, and converting said coating(s) of preceramic material to at least one silicon-containing ceramic layer by heating said preceramic material to a temperature in the range of from 50 to 800°C for a time sufficient to ceramify said preceramic material;
(ii) optionally providing onto said at least one ceramic layer of step (i) at least one additional coating selected from SiO₂ coatings, SiO₂ -ceramic oxide coatings, silicon-containing coatings, silicon-carbon-containing coatings, silicon-nitrogen-containing coatings, silicon-oxygen-nitrogen coatings, silicon-nitrogen-carbon-containing coatings and/or diamond-like carbon coatings;
(iii) removing by etching at least a portion of said ceramic layer(s) of step (i) and of said additional coating(s), if any, of step (ii) covering said bond pad(s) to allow for the attachment of leads thereto;
(iv) sealing the open bond pad(s) by covering the pad(s) with one or more non-corroding, conductive layers; and
(v) interconnecting said circuit subassembly to form the desired hermetically sealed integrated circuit.

2. A method according to claim 1, further comprising the step of:
(vi) applying, after etching step (iii) and before the application of the non-corroding conductive layer or layers of step (iv), a diffusion barrier metal layer to said bond pad(s).

3. A method according to claim 1 or claim 2, and further comprising the step of:
(vii) applying at least one further ceramic coating after the provision of said non-corroding conductive layer or layers of step (iv) and before interconnecting step (v) to provide a further seal of said circuit subassembly, and etching back a portion of said further ceramic coating(s) to expose said bond pad(s) to be interconnected.

4. A method according to any of claims 1-3, wherein said ceramic layer(s) is (are) opaque to ultraviolet and visible light.

## Patentansprüche

1. Verfahren zur Herstellung eines hermetisch dichten integrierten Schaltkreises, welches die Folge der Stufen umfaßt, in denen man:
(i) im Waferstadium vor dem Zusammenschalten des Schaltkreises auf eine Schaltkreisbaugruppe, die ein Halbleitersubstrat mit mindestens einer Anschlußstelle einschließt, mindestens eine präkeramische Beschichtung aufbringt, die ein Silicium enthaltendes präkeramisches Material enthält, das ausgewählt ist aus Hydrogensilsesquioxanharzen (H-Harzen) mit Einheiten der Struktur HSi(OH)ₓ (OR)_{y}O_{z/2}, in der R jeweils unabhängig einen organischen Rest bezeichnet, der einen hydrolysierbaren Substituenten bildet, wenn er über das Sauerstoffatom an Silicium gebunden ist, x = 0-2, y = 0-2, z = 1-3 und x + y + z = 3 ist, wobei verschiedene Einheiten der H-Harze entweder 0 oder mehr als eine Si-H-Bindung haben, und aus hydrolysierten oder teilhydrolysierten Verbindungen der Formel RₙSi(OR)₄₋ₙ, in der R jeweils unabhängig einen aliphatischen, alicyclischen oder aromatischen Substituenten mit 1 bis 20 Kohlenstoffatomen bedeutet und n = 0-3 ist, und die Beschichtung(en) aus präkeramischem Material in mindestens eine Silicium enthaltende keramische Schicht umwandelt, indem man das präkeramische Material für eine genügend lange Zeit auf eine Temperatur im Bereich von 50 bis 800°C erhitzt, um das präkeramische Material zu keramifizieren;
(ii) gegebenenfalls die mindestens eine keramische Schicht der Stufe (i) mit mindestens einer zusätzlichen Beschichtung versieht, die ausgewählt ist aus SiO₂-Beschichtungen; Beschichtungen aus SiO₂ und keramischen Oxiden; Silicium enthaltenden Beschichtungen; Silicium und Kohlenstoff enthaltenden Beschichtungen; Silicium und Stickstoff enthaltenden Beschichtungen; Silicium, Sauerstoff und Stickstoff enthaltenden Beschichtungen; Silicium, Stickstoff und Kohlenstoff enthaltenden Beschichtungen und/oder diamantartigen Kohlenstoffbeschichtungen;
(iii) durch Ätzen mindestens einen Anteil der keramischen Schicht(en) aus der Stufe (i) und gegebenenfalls der zusätzlichen Schicht(en) aus der Stufe (ii), die die Anschlußstelle(n) bedecken, entfernt, so daß dort Leitungen angebracht werden können;
(iv) die offene(n) Anschlußstelle(n) abdichtet, indem man die Anschlußstelle(n) mit einer oder mehreren nichtkorrodierenden, leitfähigen Schichten bedeckt; und
(v) die Schaltkreisbaugruppe zusammenschaltet, um den gewünschten hermetisch dichten integrierten Schaltkreis herzustellen.

2. Verfahren nach Anspruch 1, das die weitere Stufe umfaßt, in der man:
(vi) nach der Ätzstufe (iii) und vor dem Aufbringen der nichtkorrodierenden leitfähigen Schicht oder Schichten in der Stufe (iv) eine Metallschicht als Diffusionssperre auf die Anschlußstelle(n) aufbringt.

3. Verfahren nach Anspruch 1 oder 2, das die weitere Stufe umfaßt, in der man:
(vii) nach dem Aufbringen der nichtkorrodierenden leitfähigen Schicht oder Schichten in der Stufe (iv) und vor dem Zusammenschalten in der Stufe (v) mindestens eine weitere keramische Beschichtung aufbringt, um eine weitere Abdichtung der Untergruppe des Schaltkreises zu schaffen, und einen Anteil der weiteren keramischen Beschichtung(en) wegätzt, um die Anschlußstelle(n) freizulegen, die zusammengeschaltet werden sollen.

4. Verfahren nach einem der Ansprüche 1 bis 3, wobei die keramische(n) Schicht(en) opak für ultraviolettes und sichtbares Licht ist (sind).

## Revendications

1. Un procédé pour conférer à un circuit intégré une protection hermétique, qui comprend les opérations consistant, successivement :
(i) à appliquer, au stade tranche, avant interconnexion dudit circuit, à un sous-ensemble de circuit comprenant un substrat semiconducteur portant au moins un plot de connexion, au moins un revêtement précéramique comprenant une matière précéramique contenant du silicium choisie parmi les résines d'hydrogénosilsesquioxanes (résines H) comportant des motifs de structure HSi(OH)ₓ(OR)_{y}O_{z/2}, où chaque R est indépendamment un groupe organique qui, lorsqu'il est lié au silicium par l'intermédiaire de l'atome d'oxygène, forme un substituant hydrolysable, x est un nombre valant 0 à 2, y est un nombre valant 0 à 2, z est un nombre valant 1 à 3 et x + y + z = 3, divers motifs desdites résines H comptant plusieurs liaisons Si-H ou bien n'en comptant aucune, et les composés hydrolysés ou partiellement hydrolysés de formule RₙSi(OR)₄₋ₙ, où chaque R est indépendamment un substituant aliphatique, alicyclique ou aromatique comptant 1 à 20 atomes de carbone et n vaut 0 à 3, et à transformer le ou lesdits revêtements de matière précéramique en au moins une couche céramique contenant du silicium par chauffage de ladite matière précéramique à une température se situant dans l'intervalle de 50 à 800°C pendant un temps suffisant pour céramiser ladite matière précéramique ;
(ii) facultativement, à ménager par-dessus la ou lesdites couches céramiques de l'opération (i) au moins un revêtement additionnel choisi parmi les revêtements de SiO₂, les revêtements de SiO₂ et d'oxydes céramiques, les revêtements contenant du silicium, les revêtements contenant du silicium et du carbone, les revêtements contenant du silicium et de l'azote, les revêtements contenant du silicium, de l'oxygène et de l'azote, les revêtements contenant du silicium, de l'azote et du carbone et/ou les revêtements de carbone semblable au diamant ;
(iii) à éliminer par attaque chimique au moins une portion de la ou desdites couches céramiques de l'opération (i) et du ou desdits revêtements additionnels, s'il en existe, de l'opération (ii) couvrant le ou lesdits plots de connexion pour permettre d'y attacher des conducteurs ;
(iv) à protéger hermétiquement le ou les plots de connexion découverts en les couvrant d'une ou plusieurs couches conductrices non corrosives ; et
(v) à interconnecter ledit sous-ensemble de circuit pour former le circuit intégré à protection hermétique désiré.

2. Un procédé selon la revendication 1, comprenant en outre l'opération consistant :
(vi) à appliquer, après l'opération d'attaque chimique (iii) et avant l'application de la ou des couches conductrices non corrosives de l'opération (iv), une couche métallique formant barrière de diffusion au ou auxdits plots de connexion.

3. Un procédé selon la revendication 1 ou la revendication 2, comprenant en outre l'opération consistant :
(vii) à appliquer au moins un revêtement céramique supplémentaire après la formation de la ou des couches conductrices non corrosives de l'opération (iv) et avant l'opération d'interconnexion (v) pour former une protection étanche supplémentaire dudit sous-ensemble de circuit, et à réattaquer chimiquement une portion du ou desdits revêtements céramiques supplémentaires pour découvrir le ou lesdits plots de connexion à interconnecter.

4. Un procédé selon l'une quelconque des revendications 1 à 3, dans lequel la ou lesdites couches céramiques sont opaques pour la lumière ultraviolette et pour la lumière visible.
